(19) **Europäisches Patentamt / European Patent Office / Office européen des brevets**

(11) **EP 2 270 477 B1**

(12) **EUROPEAN PATENT SPECIFICATION**

(45) Date of publication and mention of the grant of the patent:
**09.09.2015 Bulletin 2015/37**

(51) Int Cl.:
*H01L 31/103* (2006.01)     *G01N 21/64* (2006.01)

(21) Application number: **09164603.4**

(22) Date of filing: **03.07.2009**

(54) **System and method for detecting luminescence**

System und Verfahren zur Lumineszenzdetektion

Système et procédé de détection de la luminescence

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(43) Date of publication of application:
**05.01.2011 Bulletin 2011/01**

(73) Proprietor: **NXP B.V.**
**5656 AG Eindhoven (NL)**

(72) Inventors:
• **Lenoble, Damien**
**Redhill, Surrey RH1 1DL (GB)**
• **Surdeanu, Radu**
**Redhill, Surrey RH1 1DL (GB)**

(74) Representative: **Hardingham, Christopher Mark et al**
**NXP Semiconductors**
**Intellectual Property and Licensing**
**Red Central**
**60 High Street**
**Redhill, Surrey RH1 1SH (GB)**

(56) References cited:
WO-A-2008/012705     DE-A1- 10 228 309
US-A1- 2003 178 578     US-A1- 2004 249 227
US-A1- 2008 037 008

**Description**

The invention relates to luminescence detection systems and methods.

One example of luminescence used in detection systems is fluorescence, and an example of the use of fluorescence detection is in nucleic acid testing (NAT). This is a core element in molecular diagnostics for detecting genetic predispositions for diseases, for determining RNA expression levels or identification of pathogens, like bacteria and viruses that cause infections.

The detection of fluorescence can be used both for a qualitative determination of the presence of a particular target DNA sample, and for a quantitative determination of the amount of DNA present in a sample. This invention relates to the apparatus used to detect the fluorescence, and the method of use.

In a typical molecular diagnostic experiment, a bio-sample is screened for detection of certain biological components (the "target"), such as genes or proteins. This is done by detecting the occurrence of selective bindings (known as hybridisation) of the target to a capture probe, which is attached to a solid surface. The hybridisation step is typically followed by a washing step, where all unbounded target molecules are flushed away, and finally a detection step is carried out.

The detection is based on fluorescent detection of fluorescent labels attached to the target molecules. Ideally, the fluorescent detection needs to be capable of single fluorescent label detection, while the process is kept time effective.

The fluorescence is induced by an excitation light signal, and a photosensor is used for the fluorescence detection.

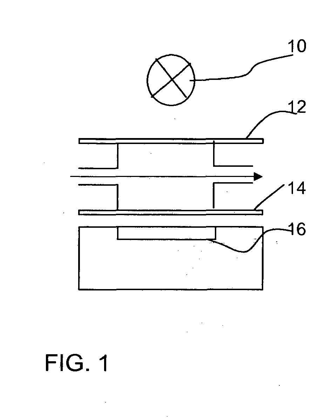

A conventional configuration is shown in Figure 1. The excitation light source 10 generates excitation light at a first wavelength $\lambda_1$ and this provokes the fluorescence emission from the fluoromarkers at a second wavelength $\lambda_2$.

A conventional configuration is shown in Figure 1. The excitation light source 10 generates excitation light at a first wavelength $\lambda_1$ and this provokes the fluorescence emission from the fluoromarkers at a second wavelength $\lambda_2$. A first filter 12 is centered on $\lambda_1$ and this means the excitation light source does not need to have a very narrow frequency bandwidth. The filtered excitation light enters a channel where there is a flow of the fluoromarkers as represented by the arrow. A second filer 14 is centered on $\lambda_2$ and thus prevents the excitation light reaching the photosensor 16. The relatively small difference in frequency between the excitation light and the fluorescence emission means that high quality optical filters are required, which add to the expense of the system. Typical filters in fluorometers have a FWHM (full width at half maximum) of 10nm, whereas commercial filters typically have a FWHM of 40 to 45nm. These high quality filters also have to be integrated into the structure and focused on the photosensor.

There is therefore a need for an optical analysis system and method in which the excitation and emission frequencies can be discriminated without the need for high quality filters.

According to the invention, there is provided a luminescence detection system, as defined in claim 1.

This arrangement uses separate detector measurements which are responsive to two different incident light profiles. By detecting light which has been absorbed over different depth ranges, the two detector element measurements will be different for different incident frequencies. This enables the two different frequency components to be separated, essentially by solving simultaneous equations. This can avoid the need for any optical filtering.

The detector comprises a detector element and biasing means for setting different operating conditions for the detector element to change the absorption depth to which the detector responds.

The detector comprises one p-n junction, so that the junction depletion regions define the depths over which there is detection of the incident light. The effective p-n junction depth can be controlled by setting different bias conditions.

The detector preferably provides a current output representing the integration of incident light over a time period. This is the nature of a photodiode output. A pulsing arrangement can be provided for pulsing the excitation source, so that different integration times can be employed for different excitation pulses. A timing arrangement is then provided for timing the time period over which the detector provides integration of incident light relative to the end of a respective excitation source pulse, and the processing means is for processing the first and second detector signals for a set of different time periods.

The System of the invention can be used in a biological component screening system.

The invention also provides a method of measuring a luminescence from a sample using an illumination detection system, comprising:

   generating excitation radiation of a first frequency;
   providing the excitation radiation to an analysis region of a sample;
   detecting light of a second frequency collected from an analysis region of the sample resulting from the excitation by generating first and second detector signals, responsive to incident light absorbed over different depths; and
   processing the first and second detector signals to discriminate between incident light of the first and second frequencies and thereby determine the intensity of the light of the second frequency.

This method enables signal processing, rather than optical processing, to be used to discriminate between the different frequency components of the light incident on the detector.

Examples of the invention will now be described in detail with reference to the accompanying drawings, in which:

Figure 1 shows in schematic form the layout of a known fluorescence detector;

Figure 2 shows how the fluorescence light decays exponentially over time;

Figure 3 is used to explain how a pulsed excitation source can be used to enable the exponential decay function can be modelled;

Figure 4 shows how there can be overlap of the excitation light and the fluorescence even when a pulsed excitation source is used;

Figure 5 shows an example of detector structure which can be used to implement the invention;

Figure 6 shows how doping can be controlled as a function of depth to give abrupt junctions;

Figure 7 shows how the absorption depth varies with wavelength;

Figure 8 shows an example of processing sequence of the invention;

Figure 9 shows a device of the invention.

The invention relates to an optical analysis apparatus and method in which a detector provides two different signals, based on responses to incident light absorbed within the detector over different depths. These signals are processed to discriminate between incident light of two different frequencies and thereby determine the intensity of the light of one desired frequency.

Before describing the invention in further detail, the basic processes involved in fluorescent emission will first be discussed. The excitation of a molecule, by adsorbing photons, causes it to move to an excited state, from which emission of fluorescence light takes place, as well as emission of heat. It can also result in photobleaching (the photochemical destruction of a fluorophore). It is well known that loss of signal strength caused by photobleaching can be controlled by reducing the intensity or time-span of the light exposure, by increasing the concentration of fluorophores, or by employing more robust fluorophores that are less prone to bleaching.

The excited state has a lifetime of 1 to 10ns.

The fluorescent emission has a wavelength profile centered one Stokes shift (of the particular fluorophore) above the centre of the absorption wavelength profile. This may be of the order of 100nm.

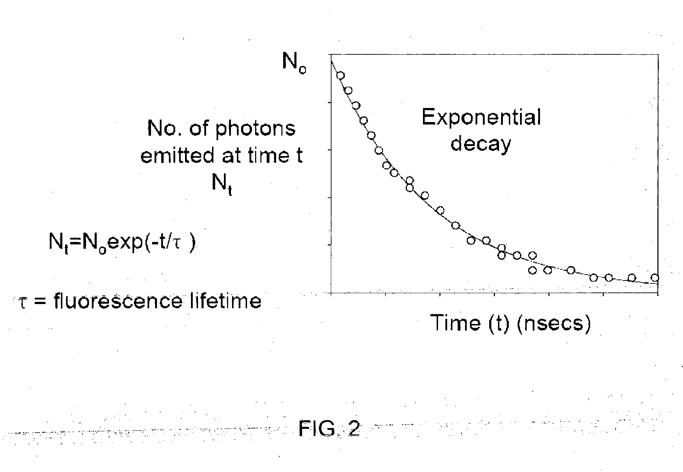

The use of pulse excitation is known, and as indicated above, this can reduce photobleaching. The fluorescence lifetime refers to the average time the molecule stays in its excited state before emitting a photon. Fluorescence typically follows first-order kinetics giving an exponential decay in the number of photons emitted as shown in Figure 2.

This lifetime profile is a signature of the particular fluoromarker. Furthermore, time resolved fluorescence measurement (to plot the profile of Figure 2) can in principle be used to derive the value No which is an indicator of the initial concentration of excited fluorophores.

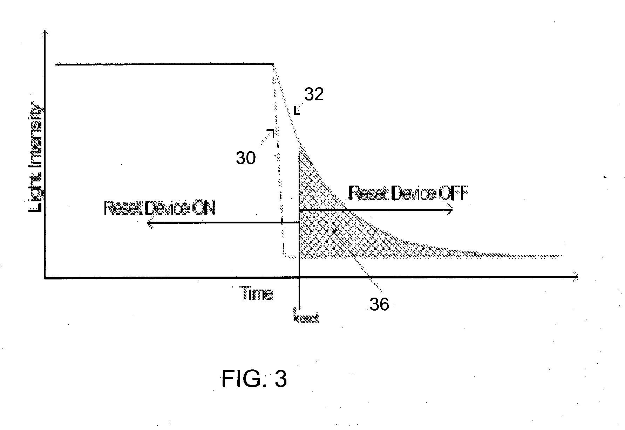

Figure 3 shows how time resolved measurements can be used to model the exponential decay.

The excitation light intensity is shown as 30, and the fluorescent decay is shown as 32. The photosensor acts as an integrator, accumulating charge in response to detected photons. Thus, it cannot be used for instantaneous intensity measurement. Instead, at a reset time 34, the photosensor starts integrating the incident light, so that the area 36 can be measured.

However, by performing repeated measurements of different areas 36, by selecting different reset instants 34, the decay characteristics can be determined.

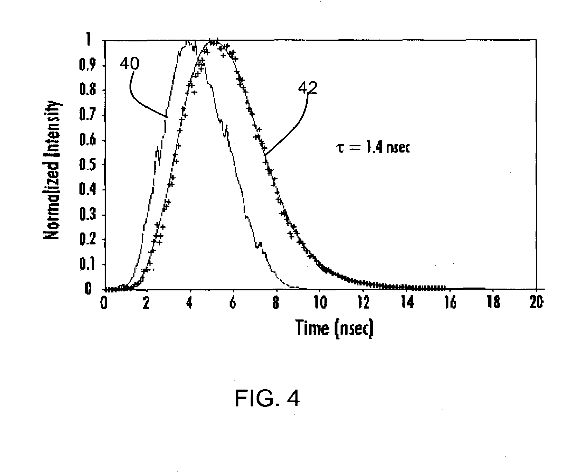

An issue with this approach of time-resolved pulse measurements is that the laser decay time can overlap with the fluorescence signal, as shown in Figure 4. The excitation profile is shown as 40 and the emission profile is shown as 42.

This invention is based on an analysis of the photosensor response to the incident light. In particular, this analysis can enable discrimination between incident light from the excitation source and the fluorescence light. The light-induced excess carrier generation in a silicon photosensor is dependent on the depth, and is given by:

$$g(x) = \frac{\varphi.q.S.\lambda}{hc}\left[\alpha.\exp(-\alpha x)\right]$$

wherein $\varphi$ is the radiation intensity, $\lambda$ is the wavelength, $\alpha$ is the absorption coefficient, S is the sensor area, q the elementary charge, c the speed of light in vacuum and h Planck's constant.

These excess carriers contribute to the measured current. In particular, excess carriers are collected from x=0 (the surface) to depth w, and contribute to a current given by:

$$I = -q \int_0^w g(x)dx = -\frac{\varphi.q.S.\lambda}{hc}(1 - e^{-\alpha w})$$

This depth w is essentially the depth of the p-n junction, and the region between the surface of the device and the depth w is the depletion region of the p-n junction. With two wavelengths (excitation and fluorescent emission) and with two different depths $w_1$ and $w_2$ (for example $w_2$ larger than $w_1$):

$$I_1 = -\frac{\varphi_1.q.S.\lambda_1}{hc}(1 - e^{-\alpha_1 w_1}) + -\frac{\varphi_2.q.S.\lambda_2}{hc}(1 - e^{-\alpha_2 w_1})$$

$$I_2 = -\frac{\varphi_1.q.S.\lambda_1}{hc}(1 - e^{-\alpha_1 w_2}) + -\frac{\varphi_2.q.S.\lambda_2}{hc}(1 - e^{-\alpha_2 w_2})$$

The two current measurements are at slightly different times, with two excitation pulses for each reset time, so that each photocurrent is measured independently. It is possible also for simultaneous current measurement to be carried out (so that the excess carriers induced in region 0 to w1 are shared between both current signals). A deconvolution is then possible to derive the same information.

By providing current measurements in respect of the excess carriers generated within two different depths of the silicon of the photosensor, two simultaneous equations are obtained, and these enable resolution between the two wavelengths - one of the excitation source and one of the fluorescence emission.

In this way, from the two current measurements, taken in a time resolved manner as explained above in connection with Figure 3, the fluorescence intensity and signature can be obtained.

The measurement of the incident light over different depths can be achieved with two photodiodes of different design. However, a single structure can define both depth sensors in a single package.

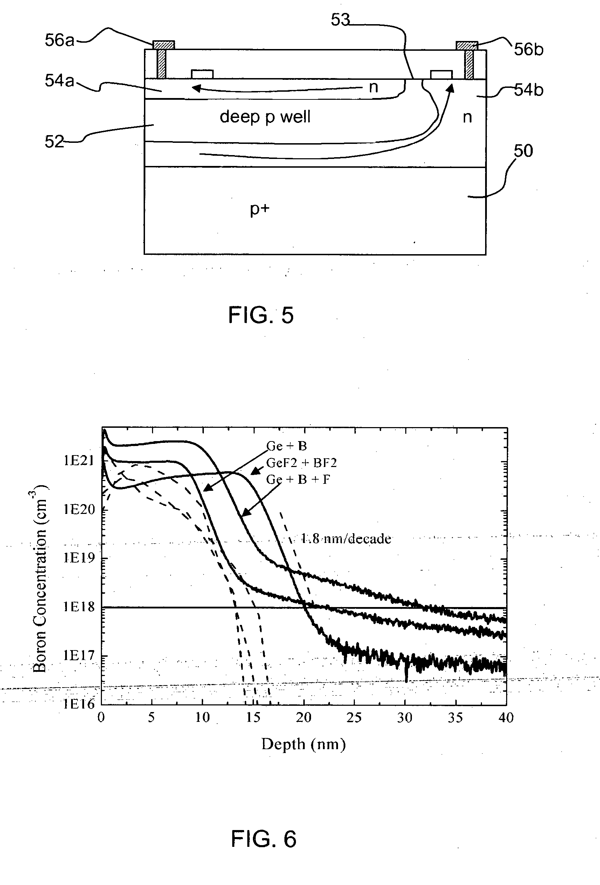

An example is schematically shown in Figure 5. This comprises a multiple well CMOS structure, with a p-doped substrate 50. A deep p-well 52, which includes a region 53 extending to the device surface, provides separation between two n-type wells 54a, 54b. The diode contacts are shown as 56a,56b, and as shown schematically by arrows, each diode essentially has a different p-n junction depth. The different depth photodiode junctions can be fabricated in a standard process using well implants and anneals.

The photodiode structure can be designed specific to the analysis to be carried out, depending on the excitation and emission wavelengths. The top junction will mainly filter the carriers induced from the excitation light, and the bottom junction will be sensitive mainly to the carriers induced by the fluorescence. The two junctions can be connected to different read out transistors to enable the signals to be independently monitored.

In one example, the excitation light is at 355nm, and this is mainly absorbed within the first 30nm of the silicon, as a result of a high absorption coefficient. The fluorescence light at 460nm is mainly absorbed within the first 300nm of silicon as a result of a medium absorption coefficient. These differences enable the different depth measurements to distinguish between the incident light frequencies.

The example above provides two different detector elements to provide detector signals which result from absorption over different ranges of depth. An alternative is to use a single p-n junction, but operate it at different bias conditions (i.e. p-n junction voltages), as these bias conditions can be used to set the effective depth of the p-n junction.

The photodetector has the following characteristics:

- the p-n junction depth *without bias applied to on the junction* is centered to the lowest wavelength intended to be measured (this lowest wavelength is usually in the UV range, and this gives a desired junction depth of around 20nm);
- a high active dopant concentration is used and a highly abrupt junction.
  This can be obtained by pre-amorphization implants, dopant implants and laser annealing.

These measures can obtain junction abruptness down to 2nm per decade change in the doping level. This is shown in Figure 6, which plots the change in boron concentration over depth for three examples of Boron doping scheme for a Germanium substrate (Ge +B; GeF2 + BF2; Ge + B + F).

The highly abrupt junction *with bias* is used to extremely accurately extend the depletion region down to the depth which corresponds to the wavelength intended to be detected.

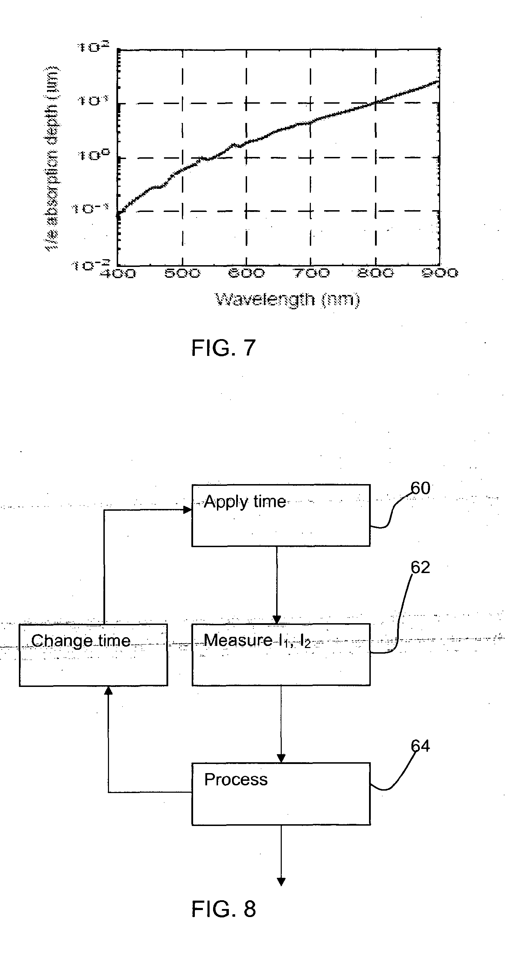

Figure 7 plots the change in absorption depth versus wavelength.

A sense and force electrical connection is applied to the junction. The position of the depletion region will determine the wavelength to be detected, and sensing using the same photodetector results in the collection of current due to the excitation or emission photons.

The bias required depends on the active doping level. By way of example, for doping levels of $10^{20}/cm^2$, and a bias of 1.5 V, a 100 nm shift can be obtained in the p-n junction position. The higher the bias, the higher the shift. Also, the higher the active doping levels and the more abrupt the junction, the higher the sensitivity is to the applied bias.

For a standard doped junction with active levels of approximately $10^{19}/cm^2$, a 100 nm change in the junction position between 100nm ($10^{-1}$ $\mu m$) and 200nm ($10^{-0.7}$ $\mu m$), will mean a change in the absorbed wavelength of about 80-90 nm (from 400 nm to 480-490 nm). This can be seen from Figure 8. The 480-490nm wavelength range is in the relevant range for the thrombine peptide fluoromarker, for example.

The positioning of the p-n junction near the surface of the device is because blue light is absorbed within a very shallow portion of doped silicon. Especially if the excitation wavelength is UV, e.g. 355 nm, the absorption layer has to be very shallow, of the order of 20 nm (as mentioned above), or more generally 20nm-40nm. Thus, the depletion region extends from the surface to the p-n junction depth as the n-type region is fully depleted, with the p-n junction at a less than the size of the depletion region.

The same processing of signals can be carried out as explained for the two-detector example.

The equations above assume the photocurrent is generated by absorption from the surface to the p-n junction depth.

The invention enables a very low cost filter-less solution for fluorescence signal detection and fluoromarker concentration determination. The two-sensor approach enables clear separation of the carriers induced by excitation light and those induced by fluorescence.

The sensor arrangement can easily be implemented using known CMOS technology.

The processing required to model the exponential decay function of the fluorescence light will be routine to those skilled in the art, once the recognition that set of pairs of simultaneous equations can be processed, with the pairing of sensor signals enabling separation between the excitation light and the light being measured.

Figure 8 shows schematically the processing required. In step 60, a reset time is selected, at a point in time after the end of an excitation pulse. In step 62, a pair of currents are measured, either from different detector elements or from the same detector with different bias conditions. Steps 60 and 62 are repeated for different reset times, so that the exponential decay function can be reconstructed. This reconstruction is in step 64, and enables specific fluorophores to be identified by their decay function, as well as the concentration, which influences the initial excitation light intensity. In order to reconstruct the exponential function, the number of different reset times may typically be in the range 5-20.

The invention enables a very simple sensor structure, in which there is no need for any separation of the excitation light and collected light. For example, there is no need for dichroic mirrors or other filters, to provide separate routing for the different light wavelengths.

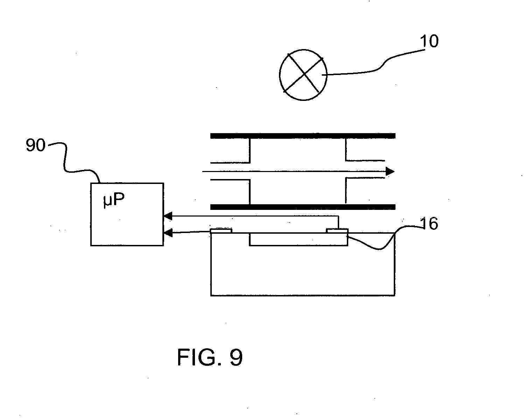

Figure 9 shows an example of the sensor of the invention. As in the prior art, the excitation light source 10 generates excitation light at a first wavelength $\lambda_1$ and this provokes the fluorescence emission from the fluoromarkers at a second wavelength $\lambda_2$. However, no filters are required. A processor 90 processes the signals from the detector 16 to enable separation of the contribution of the two different wavelengths incident on the detector. The contacts for reading the detector current are also used to apply the bias when the detector is as described in the second example above, and this biasing is implemented by the processor 90.

The description above relates to fluorescence detection. However, the invention more generally relates to the excitation of a sample and the detection of resulting light. The induced luminescence can for example comprise phosphorescence.

Two examples have been given of how to obtain photosensor signals which are in respect of different depths of light absorption in the detector. Other approaches are possible - for example the use of two completely separate detectors side by side. One example of set of processing equations has been given. However, the equations are an approximation, and variations are possible. The parameters needed to solve the simultaneous equations can be found by experiment or by theory, or a combination of these.

In the case of bio-sampling, the sample typically is screened for certain components, e.g. biological components such as oligonucleotides, DNA, RNA, genes, proteins, carbohydrates, lipids, cells, cell components such as external cell membranes or internal cell membranes, bacteria, viruses, protozoa, etc. also called the target particles.

Luminescent labels typically are attached to the target particles and thus assist in the detection of target particles. These labels can for instance be fluorescent (as described above), electroluminescent or chemoluminescent particles. The labels may be any entity that is capable to bind to a binding site mechanically, electrically, chemically or otherwise. They may comprise single molecules or a plurality of molecules, preferably a collection of between 10 to $10^8$ molecules and/or quantum dot-like labels. If a plurality of molecules is used, typically a stronger response to the excitation is obtained, resulting in a better signal-to-noise ratio.

The applications of the invention are generally in the field of molecular diagnostics: clinical diagnostics, point-of-care diagnostics, advanced bio-molecular diagnostic research - biosensors, gene and protein expression arrays, environmental sensors, food quality sensors, etc.

Various other modifications will be apparent to those skilled in the art.

**Claims**

1.   A system for detecting luminescence from a sample, comprising:

an excitation radiation source (10) of a first frequency; and
a detector (16) for detecting light of a second frequency collected from an analysis region of the sample resulting from the excitation,
wherein the detector is for generating first and second detector signals, which are responsive to incident light absorbed within the detector over different depths, and wherein the system further comprises:

means (90) for processing the first and second detector signals to discriminate between incident light of the first and second frequencies and thereby determine the intensity of the light of the second frequency, wherein the detector (16) comprises a p-n junction and biasing means (90) for setting different operating conditions for the p-n junction to change the absorption depth to which the detector responds.

2.   A system as claimed in claim 1, wherein the detector (16) provides a current output representing the integration (36) of incident light over a time period.

3.   A system as claimed in claim 2, further comprising a pulsing arrangement for pulsing (30) the excitation source.

4.   A system as claimed in claim 3, further comprising a timing arrangement for timing the time period over which the detector provides integration of incident light relative to the end of a respective excitation source pulse (30), and wherein the processing means (90) is for processing the first and second detector signals for a set of different time periods.

5.   A system as claimed in any preceding claim, comprising a biological component screening system.

6.   A method of measuring a luminescence from a sample using a system according to one of the claims 1 to 5, comprising:

generating excitation radiation of a first frequency;
providing the excitation radiation to an analysis region of the sample;
detecting light of a second frequency collected from an analysis region of the sample resulting from the excitation by generating first and second detector signals responsive to incident light absorbed within the detector over different depths; and
processing the first and second detector signals to discriminate between incident light of the first and second frequencies and thereby determine the intensity of the light of the second frequency,
wherein the detector signals are derived from a p-n junction with different bias conditions, to change the absorption depth to which the detector responds.

7.   A method as claimed in claim 6, wherein generating first and second detector signals comprises generating a current output representing the integration of incident light over a time period.

8.   A method as claimed in claim 7, further comprising pulsing the excitation source.

9.   A method as claimed in claim 8, further comprising timing the time period over which the detector elements provide integration of incident light relative to the end of a respective excitation source pulse, and wherein the processing comprises processing the first and second detector element signals for a set of different time periods.

10.  A method as claimed in any one of claims 6 to 9, wherein detecting light comprises collecting fluorescence illumination from the sample.

**Patentansprüche**

1. Ein System zum Detektieren von Lumineszenz von einer Probe, aufweisend:

   eine Anregungsstrahlungsquelle (10) von einer ersten Frequenz; und
   einen Detektor (16) zum Detektieren von Licht von einer zweiten Frequenz, welches resultierend aus der Anregung aus einem Analysebereich von der Probe gesammelt ist,
   wobei der Detektor zum Generieren von einem ersten Detektorsignal und von einem zweiten Detektorsignal ist, welche auf einfallendes Licht ansprechen, welches innerhalb des Detektors über verschiedene Tiefen absorbiert ist, und wobei das System ferner aufweist:

   Mittel (90) zum Verarbeiten des ersten Detektorsignals und des zweiten Detektorsignals, um zwischen einfallendem Licht von der ersten Frequenz und von der zweiten Frequenz zu unterscheiden und um dadurch die Intensität von dem Licht von der zweiten Frequenz festzustellen,
   wobei der Detektor (16) aufweist
   einen p-n Übergang und
   ein vorspannendes Mittel (90) zum Setzen verschiedener Betriebsbedingungen für den p-n Übergang, um die Absorptionstiefe zu verändern, auf welche der Detektor anspricht.

2. Ein System gemäß Anspruch 1, wobei der Detektor (16) eine Stromausgabe bereitstellt, welche die Integration (36) von einfallendem Licht über eine Zeitperiode repräsentiert.

3. Ein System gemäß Anspruch 2, ferner aufweisend eine pulsierende Anordnung zum Pulsieren (30) der Anregungsquelle.

4. Ein System gemäß Anspruch 3, ferner aufweisend eine Timing Anordnung zum Timen der Zeitperiode, über welche der Detektor die Integration von einfallendem Licht relativ zu dem Ende von einem jeweiligen Anregungsquellen Puls (30) bereitstellt, und
   wobei das verarbeitende Mittel (90) zum Verarbeiten des ersten Detektorsignals und des zweiten Detektorsignals für einen Satz von verschiedenen Zeitperioden ist.

5. Ein System gemäß einem beliebigen vorhergehenden Anspruch, aufweisend ein biologische Komponente Screening System.

6. Ein Verfahren zum Messen einer Lumineszenz von einer Probe unter Verwenden eines Systems gemäß einem von den Ansprüchen 1 bis 5, aufweisend:

   Generieren von Anregungsstrahlung von einer ersten Frequenz;
   Bereitstellen der Anregungsstrahlung an einen Analysebereich von der Probe;
   Detektieren von Licht von einer zweiten Frequenz,
   welches aus einem Analysebereich von der Probe gesammelt wird,
   welches aus der Anregung mittels Generierens eines ersten Detektorsignals und eines zweiten Detektorsignals resultiert, welche auf einfallendes Licht ansprechbar sind, welches innerhalb des Detektors über verschiedene Tiefen absorbiert wird; und
   Verarbeiten des ersten Detektorsignals und des zweiten Detektorsignals, um zwischen einfallendem Licht von der ersten Frequenz und von der zweiten Frequenz zu unterscheiden und um dadurch die Intensität von dem Licht von der zweiten Frequenz festzustellen,
   wobei die Detektorsignale von einem p-n Übergang mit verschiedenen Vorspann Bedingungen abgeleitet werden, um die Absorptionstiefe zu verändern, zu welcher der Detektor anspricht.

7. Ein Verfahren gemäß Anspruch 6, wobei das Generieren eines ersten Detektorsignals und eines zweiten Detektorsignals ein Generieren einer Stromausgabe aufweist, welche die Integration von einfallendem Licht über eine Zeitperiode repräsentiert.

8. Ein Verfahren gemäß Anspruch 7, ferner aufweisend ein Pulsieren der Anregungsquelle.

9. Ein Verfahren gemäß Anspruch 8, ferner aufweisend ein Timen der Zeitperiode über welche die Detektorelemente die Integration von einfallendem Licht bereitstellen, welches relativ zu dem Ende von einem jeweiligen Anregungsquellen Puls ist, und wobei das Verarbeiten ein Verarbeiten des ersten Detektorsignals und des zweiten Detektorelementsignals für einen Satz von verschiedenen Zeitperioden aufweist.

**10.** Ein Verfahren gemäß einem beliebigen von den Ansprüchen 6 bis 9, wobei das Detektieren von Licht ein Sammeln von Fluoreszenz Beleuchtung von der Probe aufweist.

**Revendications**

**1.** Système de détection de la luminance d'un échantillon, comprenant :

une source de rayonnement d'excitation (10) à une première fréquence ; et
un détecteur (16) destiné à détecter une lumière à une seconde fréquence recueillie à partir d'une région d'analyse de l'échantillon du fait de l'excitation,
dans lequel le détecteur est destiné à générer des premier et second signaux de détecteur qui sont obtenus en réponse à une lumière incidente absorbée au sein du détecteur à différentes profondeurs, et dans lequel le système comprend en outre :

un moyen (90) destiné à traiter les premier et second détecteurs afin d'effectuer une discrimination entre les lumières incidentes aux première et seconde fréquences, et ainsi déterminer l'intensité de la lumière à la seconde fréquence,
dans lequel le détecteur (16) comprend une jonction p-n et un moyen de polarisation (90) destiné à définir différentes conditions de fonctionnement pour la jonction p-n afin de modifier la profondeur d'absorption à laquelle le détecteur répond.

**2.** Système selon la revendication 1, dans lequel le détecteur (16) fournit une sortie de courant représentant l'intégration (36) de la lumière incidente au cours d'une période de temps.

**3.** Système selon la revendication 2, comprenant en outre un dispositif générateur d'impulsions destiné à faire en sorte que la source d'excitation produise des impulsions (30).

**4.** Système selon la revendication 3, comprenant en outre un dispositif de comptage de temps destiné à compter le temps de la période de temps pendant laquelle le détecteur effectue une intégration de la lumière incidente par rapport à la fin d'une impulsion respective (30) de la source d'excitation, et dans lequel le moyen de traitement (90) est destiné à traiter les premier et second signaux de détecteur pour un ensemble de périodes de temps différentes.

**5.** Système selon l'une quelconque des revendication précédentes, comprenant un système de sélection de composants biologiques.

**6.** Procédé de mesure d'une luminance provenant d'un échantillon au moyen d'un système selon l'une des revendications 1 à 5, consistant à :

générer un rayonnement d'excitation à une première fréquence ;
fournir le rayonnement d'excitation à une région d'analyse de l'échantillon,
détecter la lumière à une seconde fréquence recueillie à partir d'une région d'analyse de l'échantillon du fait de l'excitation en générant des premier et second signaux de détecteur en réponse à la lumière incidente absorbée au sein du détecteur à différentes profondeurs ; et
traiter les seconds signaux de détecteur afin d'effectuer une discrimination entre la lumière incidente aux première et seconde fréquences, et ainsi déterminer l'intensité de la lumière à la seconde fréquence,
dans lequel les signaux de détecteur sont obtenus à partir d'une jonction p-n soumise à des conditions de polarisation différentes, afin de modifier la profondeur d'absorption à laquelle le détecteur répond.

**7.** Procédé selon la revendication 6, dans lequel la génération des premier et second signaux de détecteur consiste à générer un courant de sortie représentant l'intégration de la lumière incidente au cours d'une période de temps.

**8.** Procédé selon la revendication 7, consistant en outre à faire en sorte que la source d'excitation produise des impulsions.

9. Procédé selon la revendication 8, consistant en outre à mesurer le temps de la période de temps au cours de laquelle les éléments détecteurs fournissent une intégration de la lumière incidente par rapport à la fin d'une impulsion respective de la source d'excitation, et dans lequel le traitement consiste à traiter les premier et second signaux d'éléments détecteurs pour un ensemble de périodes de temps différentes.

10. Procédé selon l'une quelconque des revendications 6 à 9, dans lequel la détection de la lumière consiste à recueillir un éclairement de fluorescence provenant de l'échantillon.

10

12

14

16

FIG. 1

$N_o$

No. of photons
emitted at time t
$N_t$

$N_t=N_o\exp(-t/\tau)$

$\tau$ = fluorescence lifetime

Exponential
decay

Time (t) (nsecs)

FIG. 2

FIG. 3

FIG. 4

**FIG. 5**

**FIG. 6**

FIG. 7

FIG. 8

FIG. 9